## Europäisches Patentamt
## European Patent Office
## Office européen des brevets

(11) Numéro de publication: **0 130 529**
**B1**

# (12) FASCICULE DE BREVET EUROPEEN

(45) Date de publication du fascicule du brevet: **18.05.88**

(51) Int. Cl.⁴: **H 04 Q 3/52,** H 04 B 9/00, H 03 K 17/693

(21) Numéro de dépôt: **84107307.5**

(22) Date de dépôt: **26.06.84**

(54) **Rétine de photodétecteurs adressables.**

(30) Priorité: **29.06.83 FR 8310719**

(43) Date de publication de la demande:
**09.01.85 Bulletin 85/02**

(45) Mention de la délivrance du brevet:
**18.05.88 Bulletin 88/20**

(84) Etats contractants désignés:
**BE DE FR GB IT LU NL SE**

(56) Documents cités:
**WO-A-80/01028**
**DE-A-1 562 037**
**US-A-4 109 284**

(73) Titulaire: **ALCATEL CIT**
**33, rue Emeriau**
**F-75015 Paris (FR)**

(72) Inventeur: **Brilman, Michel**
**3, Allée de la Vigne Dieu**
**F-91680 Bruyeres Le Chatel (FR)**

(74) Mandataire: **Weinmiller, Jürgen et al**
**Lennéstrasse 9 Postfach 24**
**D-8133 Feldafing (DE)**

Courier Press, Leamington Spa, England.

EP 0 130 529 B1

## Description

L'invention concerne une rétine de photodétecteurs adressables permettant à un abonné de sélectionner un signal optique parmi un certain nombre de signaux optiques émis chacun par une source lumineuse différente, qui peut être par exemple une fibre optique délivrant un signal analogique ou numérique, chaque source lumineuse illuminant un photodétecteur de la rétine.

Une rétine selon le préambule de la revendication 1 est connue du document WO—A—8 001 028. Chaque ligne y est reliée à un canal commun de sortie à travers un transistor déblocable par une tension appliquée sur sa grille à l'aide d'une liaison de commande de sélection de ligne, et chaque photodétecteur est relié à une ligne par l'intermédiaire d'un transistor; tous les transistors affectés à tous les photodétecteurs d'une même colonne ont leur grille reliée à une liaison de commande de colonne; une tension de commande appliquée sur la liaison de commande de colonne permet donc de relier dans la colonne le photodétecteur correspondant à la ligne sélectionnée. Lorsque le photodétecteur ainsi sélectionné reçoit et signal lumineux, un courant circule dans le canal commun de sortie. Dans une telle rétine de photodétecteurs, les photodétecteurs non sélectionnés pe peuvent écouler les charges créées lorsqu'ils reçoivent un signal optique, puisque les transistors qui les relient aux lignes sont normalement bloqués, sauf ceux de la colonne sélectionnée; il est donc nécessaire que les transistors reliant les lignes au canal commun de sortie soient effectivement bloqués ce que nécessite que leur courant de fuite soit nul ou très faible pour ne pas transmettre le courant des photodétecteurs de la colonne sélectionnée, ou encore le courant des photodétecteurs des autres colonnes si le transistor qui relie chacun d'eux à une ligne n'est plas bloqué, c'est-à-dire si son courant de fuite n'est pas nul ou très faible; dans le cas des photodétecteurs appartenant à la ligne sélectionnée leur courant viendrait perturber le courant du photodétecteur sélectionné si le transistor qui relie chacun d'eux à ladite ligne n'est pas bloqué.

La présente invention a pour but une rétine de photodétecteurs adressables ne présentant pas les inconvénients de la rétine connue, et qui soit facilement réalisable sous forme de circuit intégré.

Ce but est atteint selon l'invention par la rétine telle que définir par la revendication 1.

L'invention va être décrite ci-après à l'aide exemples de réalisation illustrés par les figures annexées dans lesquelles:

—la figure 1 est un schéma électrique d'une rétine de l'invention,

—la figure 2 est un schéma électrique d'une cellule de la rétine de la figure 1,

—la figure 3 est une variante du schéma électrique d'une cellule de la rétine de la figure 1,

—la figure 4 représente une première réalisation, sous forme de circuit intégré, d'une rétine avec une cellule de la figure 2,

—la figure 5 est une coupe selon V—V de la figure 4,

—la figure 6 représente schématiquement une partie d'une rétine conforme à la première réalisation,

La figure 7 représente une deuxième réalisation, sous forme de circuit intégré, d'une rétine avec une cellule de la figure 2,

—la figure 8 est une coupe selon VIII—VIII de la figure 7,

—la figure 9 représente schématiquement une partie d'une rétine conforme à la deuxième réalisation,

—la figure 10 représente un exemple de réalisation, sous forme de circuit intégré, d'une rétine avec une cellule de la figure 3.

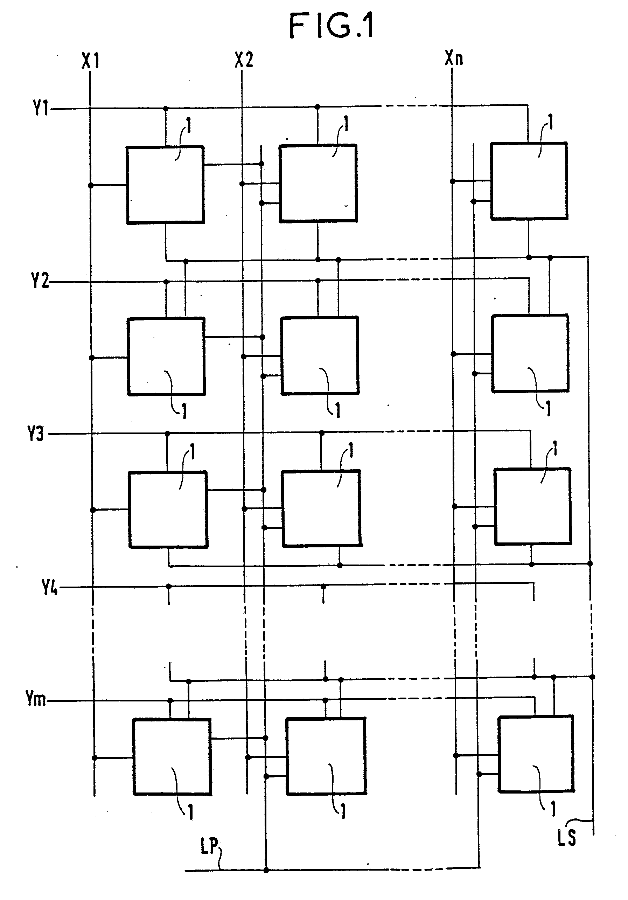

La figure 1 représente une rétine de photodétecteurs de l'invention, sous forme matricielle ayant m lignes et n colonnes et constituée de cellules 1, identiques, comportant chacune un photodétecteur, qui est une photodiode, et un circuit d'adressage. La matrice comporte des liaisons d'adressage de ligne, Y1, Y2, ... Ym, des liaisons d'adressage de colonne, X1, X2, ... Xn, une liaison de sortie LS commune à toutes les cellules et une liaison de polarisation LP commune·à toutes les cellules. Chaque cellule 1 est donc reliée à un liaison d'adressage de ligne, à une liaison d'adressage de colonne, à la liaison de sortie et à la liaison de polarisation; elle est en outre reliée à la masse, une telle liaison n'étant pas représentée sur la figure 1 afin de ne pas la surcharger. La liaison de polarisation LP est reliée à un potentiel positif d'une source de tension continue, également non représentée.

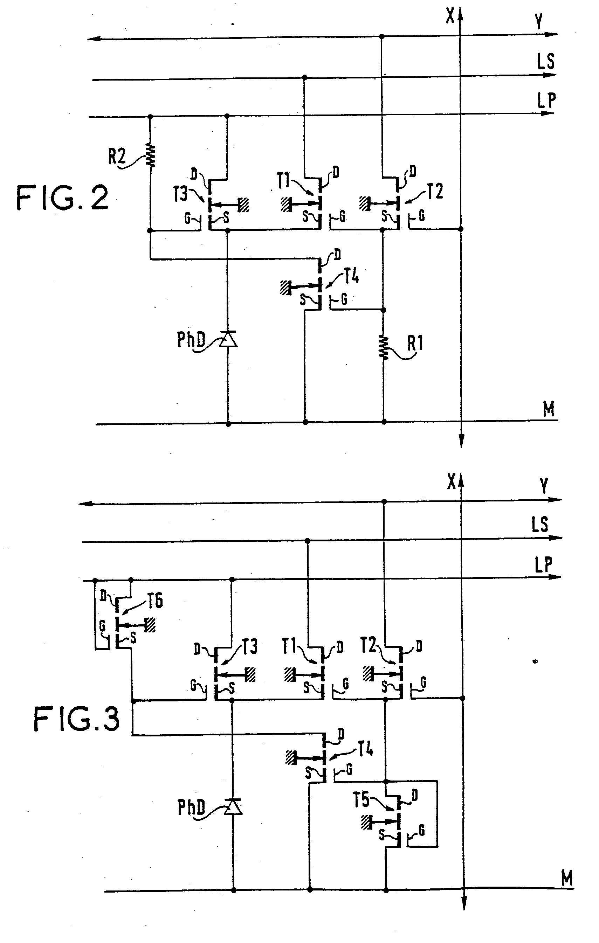

La figure 2 représente un exemple de réalisation d'une cellule 1 de la figure 1. La cellule comprend une photodiode PhD et un circuit d'adressage constitué par quatre transistors T1, T2, T3, T4 du type MOS, à canal N, normalement bloqués, et deux résistances R1, R2. La photodiode PhD est reliée d'une part à une ligne de masse M et d'autre part à la liaison de sortie LS par le transistor T1 et à la liaison de polarisation LP par le transistor T3. Le transistor T2 est en série avec la résistance R1, le transistor étant relié à la liaison d'adressage de ligne Y, la résistance étant reliée à la ligne de masse M; la grille du transistor T2 est reliée à la liaison d'adressage de colonne X; un point commun à la résistance R1 et au transistor T2 est relié à la grille du transistor T1. Le transistor T4 est en série avec la résistance R2, le transistor étant relié à la ligne de masse M, la résistance étant reliée à la liaison de polarisation LP; un point commun à la résistance R2 et au transistor T4 est relié à la grille du transistor T3; la grille du transistor T4 est reliée à un point commun au transistor T2 et à la résistance R1.

Lorsque la cellule n'est pas sélectionnée, donc en l'absence de tout signal sur les liaisons d'adressage de ligne Y et de colonne X, les transistors T1, T2 et T4 sont bloqués et le transistor T3 est passant; la photodiode PhD étant illuminée son courant s'écoule par le transistor T3 et la liaison de polarisation LP reliée à une source de tension continue. Lorsque la cellule est sélectionnée par un signal positif sur chacune des liaisons d'adressage de ligne Y et de colonne X, le transistor T2 devient passant, ce qui rend les transistors T1 et T4 passants; le transistor T4 étant passant le potentiel de la grille du transistor T3 baisse pour devenir voisin de celui de la ligne de masse M ce qui bloque le transistor T3. Le courant de la photodiode PhD s'écoule à travers le transistor T1 dans la liaison de sortie LS, cette liaison étant par exemple reliée à un préamplificateur pour amplifier le courant de la photodiode PhD, ce courant correspondant au signal lumineux reçu par la photodiode.

Dans la figure 1, lorsqu'aucune des cellules n'est sélectionnée, il n'y a donc pas courant dans la liaison de sortie LS; par contre le courant des photodiodes des cellules qui reçoivent un signal lumineux s'écoule par la liaison de polarisation LP. Lorsqu'une cellule est sélectionnée seul le courant de la photodiode de cette cellule est acheminé par la liaison de sortie LS.

La figure 3 représente une variante de réalisation d'une cellule 1 de la figure 1. Dans cette figure on retrouve les mêmes éléments, photodiode PhD, transistors T1, T2, T3, T4 que ceux de la figure 2; par contre les résistances R1 et R2 sont remplacées par deux transistors T5, T6, respectivement, également de type MOS à canal N; le transistor T5 est en série avec le transistor T2, et sa grille étant reliée au transistor T2, ce transistor T5 devient passant lorsque le transistor T2 est débloqué, et se comporte alors comme une résistance; le transistor T6 est en série avec le transistor T4, et sa grille étant reliée à la liaison de polarisation LP, ce transistor T6 est toujours passant et se comporte comme une résistance. Le fonctionnement de cette cellule est identique à celui de la cellule de la figure 2, le circuit d'adressage de la photodiode étant constitué par les transistors T1, T2, T3, T4, T5 et T6.

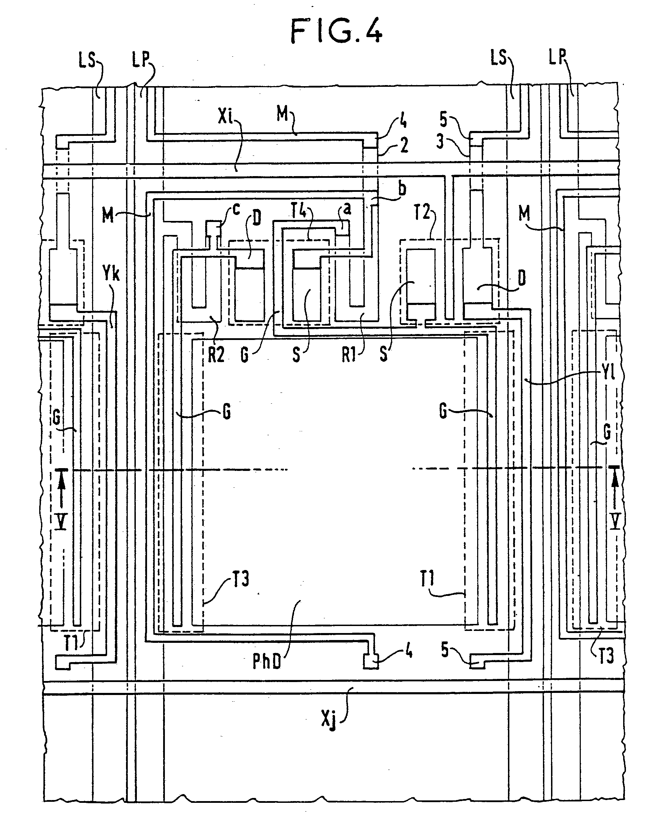

La figure 4 représente, un exemple de réalisation, sous forme de circuit intégré, d'une rétine avec la cellule de la figure 2; dans cette figure 4 on a représenté une cellule, mais bien entendu c'est toute la rétine de photodétecteurs de la figure 1 qui est réalisée sous forme de circuit intégré, la cellule représentée faisant partie de ce circuit intégré dont on précisera au cours de la description comment les cellules sont disposées.

Pour réaliser le circuit intégré on part d'une pastille d'un substrat de silicium de type $P^+$ de faible résistivité, par exemple 15 milliohms par centimètre. Sur une face de la pastille on crée une couche de type $P^-$ de forte résistivité, par exemple 10 ohms par centimètre; cette couche est obtenue par exemple par épitaxie, son épaisseur étant de l'ordre de 20 microns par exemple. On réalise, dans des zones de la couche $P^-$ de la pastille, une couche de type N, ces zones correspondant à la liaison de sortie LS, à la liaison polarisation LP, aux photodiodes PhD, aux sources S et aux drains D des transistors T2 et T4, aux résistances R1 et R2, la résistance R2 étant reliée à la liaison de polarisation LP, et à deux connexions 2 et 3, l'une 2 prolongeant la résistance R1 pour la relier à la masse et l'autre 3 prolongeant le drain D du transistor T2 pour le relier à la liaison d'adressage de ligne Y de la cellule.

La figure 4 montre ces zones de type N qui sont obtenues de manière classique par diffusion après masquage.

On crée ensuite un oxyde mince, Si O2, sur la surface de la pastille, à l'exception des zones correspondant aux photodiodes PhD et d'une partie des sources et drains des transistors T2 et T4.

On effectue ensuite une opération d'ouverture des reprises de contact pour accéder d'une part à la couche N et d'autre part à la couche $P^-$. L'accès à la couche N est fait dans certaines régions qui correspondant dans chaque cellule, et comme représenté figure 4, à une extrémité 5 de la connexion 3, aux extrémités a et b de la résistance R1, l'extrémité b étant commune à la résistance R1 et à la connexion 2, à une extrémité c de la résistance R2 opposée à la liaison de polarisation. L'accès à la couche $P^-$ est fait en un point 4 de la connexion 2 situé à l'extrémité de celle-ci opposée à l'extrémité b.

On réalise ensuite, par dépôt d'un métal bon conducteur de l'électricité, par exemple de l'aluminium, les électrodes des sources S et des drains D des transistors T2 et T4 dans les parties sans oxyde, des contacts avec les couches N ou $P^-$ dans les ouvertures de contacts, et sur l'oxyde, les électrodes des grilles des transistors T1 à T4, et un réseau d'interconnexion constitué par les liaisons d'adressage de colonne X1 à Xn et les connexions de celles-ci avec les électrodes des grilles des transistors T2, par les liaisons d'adressage de ligne Yl à Ym et les connexions de celles-ci avec les drains des transistors T2 et les extrémités 5 des connexions 3, par la ligne de masse M et les connexions de celle-ci avec les extrémités b des résistances R1 et les points 4 des connexions 2, et par des connexions internes à chaque cellule, entre les éléments de celle-ci. Ces connexions internes sont: une connexion reliant l'électrode de grille du transistor T1 à la source du transistor T2 et à l'électrode de grille du transistor T4, une connexion reliant la source du transistor T4 à l'extrémité b de la résistance R1, une connexion reliant la grille du transistor T4 à l'extrémité a de la résistance R1, et une connexion reliant l'électrode de grille du transistor T3 à l'extrémité c de la résistance R2 et au drain du transistor T4.

On effectue ensuite un traitement antireflet et passivation des photodiodes par dépôt, sur la couche N correspondante, d'une couche de nitrure de silicium $Si_3 N_4$.

La réalisation de la rétine de photodétecteur est donc simple et ne nécessite qu'un petit nombre de masques pour l'ensemble des opérations, ce que permet une fabrication économique des rétines et procure un bon rendement de fabrication.

Dans la figure 4 la liaison de polarisation LP et la liaison de sortie LS sont réalisées sous forme de barres parallèles; comme chaque liaison est commune à toutes les cellules, les barres de la liaison de polarisation sont donc réunies entre elles, et les barres de la liaison de sortie sont réunies entre elles; ceci est évidemment réalisé lors de l'opération de diffusion de la couche N et ne pose aucun problème de réalisation pour l'home de l'art. La ligne de masse M est reliée en chaque point 4 à la couche $P^-$ et par celle-ci à la couche $P^+$ du substrat, cette couche $P^+$ constituant la masse de la rétine; les photodiodes étant constituées chacune par une jonction $N/P^-$ sont donc en contact, par la couche $P^-$ avec la couche $P^+$ du substrat.

Les connexions 2 et 3 de la figure 4 sont réalisées par une couche N comme cela a été dit, ceci afin d'assurer la continuité de la liaison d'adressage de ligne par la connexion 5 et de la ligne de masse par la connexion 2 tout en permettant le croisement avec les liaisons d'adressage de colonne. Dans les zones de croisement ces connexions constituent des passage enterrés.

Sur la figure 4 on a représenté une liaison d'adressage de ligne Yk, Yl, au-dessus de chaque barre de la liaison de sortie LS de laquelle elle est isolée par la couche d'oxyde, et une liaison de masse M au-dessus de chaque barre de la liaison de polarisation LP de laquelle elle est isolée par la couche d'oxyde. A partir de la cellule représentée figure 4, l'implantation est la suivante: à gauche de la barre de la liaison de sortie LS représentée à gauche de la figure 4, on implante par glissement une cellule identique de celle de la figure 4; à droite de la barre de la liaison de polarisation LP, représentée à droite de la figure 4, on implante également, par glissement, une cellule identique à celle de la figure 4; au-dessus de la liaison d'adressage de colonne Xi, et au-dessus de la liaison d'adressage de colonne Xj, on implante une cellule obtenue également par simple glissement de la cellule représentée figure 4. La liaison d'adressage de ligne Yk est donc commune à toutes les cellules situées à gauche de la barre de la liaison de sortie LS comportant la liaison Yk et la liaison d'adressage de ligne Yl est commune à toutes les cellules situées à gauche de la barre de la liaison de sortie LS comportant la liaison Yl. La liaison d'adressage de colonne Xi est commune à toutes les cellules situées en dessous d'elle, la liaison d'adressage de colonne Xj étant commune à toutes les cellules situées en-dessous d'elle.

La cellule étant implantée par glissement horizontal et vertical, il en résulte qu'horizontalement une cellule est comprise entre deux jeux de barres, chaque de barres étant constitué par une barre de la liaison de sortie LS et une barre de la liaison de polarisation LP placées côté à côte comme illustré figure 4.

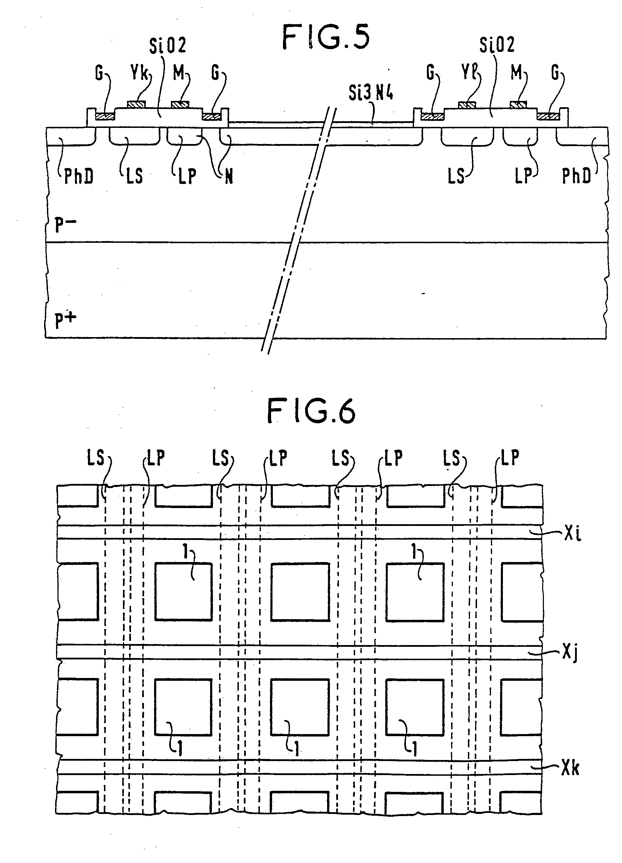

La figure 6 représenté schématiquement une partie de la rétine conforme à la figure 4 et montre l'implantation des jeux de barres de la liaison de polarisation LP et de la liaison de sortie LS avec des cellules 1 comprises entre deux jeux de barres; les liaisons d'adressage de ligne ne sont pas représentées sur les barres de la liaison de sortie.

La figure 5 est une vue en coupe selon V—V de la figure 4, à une échelle agrandie. On y retrouve les zones de type N correspondant aux photodiodes, à la barre de liaison de polarisation LP et à la barre de la liaison de sortie LS; la couche d'oxyde Si $O_2$, au-dessus des deux jeux de barres constitués chacun par une barre de la liaison de sortie et une barre de la liaison de polarisation, porte les métallisation d'aluminium correspondant aux grilles G des transistors T1 et T3, à la ligne de masse M, et une liaison d'adressage de ligne Yk à gauche et Yl à droite de la figure. La cellule représentée figure 4 est celle dont le schéma électrique est illustré par la figure 2, sur laquelle on remarque que les sources S des transistors T1 et T3 sont reliées à la cathode de la photodiode PhD, et que les drains D de ces transistors sont reliés à la liaison de sortie LS et à la liaison de polarisation LP, respectivement. La cathode, les sources, les drains et les liaisons de polarisation LP et de sortie LS sont réalisés par une couche N dans la couche $P^-$; aussi afin de limiter le nombre de connexions à réaliser, les sources des transistors T1 et T3 sont elles confondues avec la cathode de la photodiode et les drains sont-ils confondus avec la liaison de sortie pour le transistor T1 et la liaison de polarisation LP pour le transistor T3; il en découle que les sources et drains ne sont pas géométriquement délimités; c'est la raison pour laquelle, sur les figures 4 et 5, sources et drains des transistors T1 et T3 ne sont pas représentés; on remarque également sur ces figures 4 et 5, que compte tenu de l'implantation de la cellule sur la surface de la rétine qui a été donnée ci-dessus, la liaison de polarisation LP sert de drain pour les transistors T3 et que la liaison de sortie LS sert de drain pour les transistors T1. Cette disposition des sources et des drains et des cellules simplifie le masque utilisé pour l'opération de diffusion de la couche N, et le masque utilisé pour la réalisation des connexions puisque le motif d'une cellule est reproduit par glissement tant verticalement qu'horizontalement.

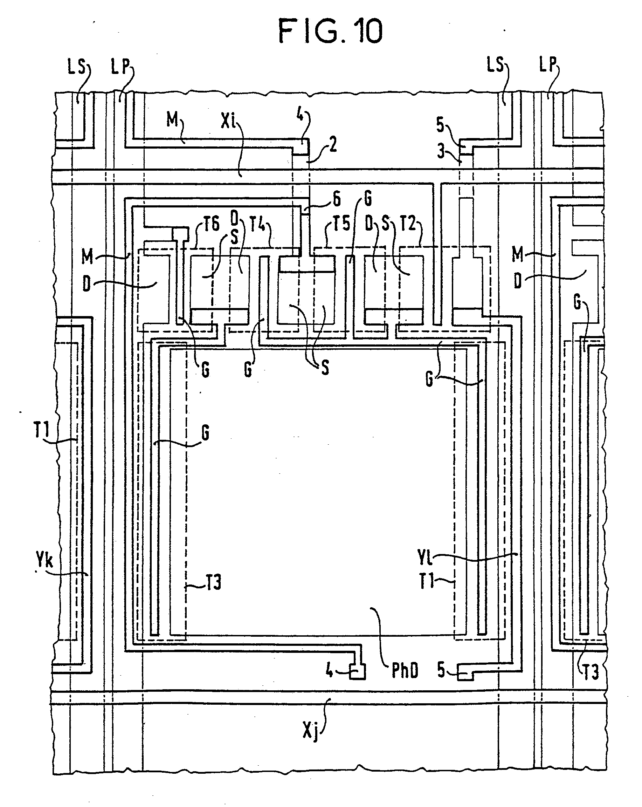

On a décrit et représenté figures 4 et 5 un exemple de réalisation de la rétine ayant des cellules du type représenté figure 2, c'est-à-dire comportant des résistances R1 et R2. Si l'on veut réaliser une rétine avec la cellule de la figure 3, on procédera comme dans le cas de la figure 4 et, on créera, comme représenté figure 10, lors de la diffusion de la couche N, des zones de type N correspondant aux sources et drains des transistors T5 et T6, et lors de la réalisation des différentes connexions, par dépôt d'aluminium, on reliera la source du transistor T6 à la grille du transistor T3, et la grille du transistor T6 à la liaison de polarisation LP, le drain du transistor T6 prolongeant la liaison de polarisation LP. Pour le transistor T5 on reliera sa source à la ligne de masse M, et son drain et sa grille à la grille du transistor T4 elle même reliée à la grille du transistor T1. La connexion 2 prolonge alors les sources des transistors T4 et T5; la connexion 2 prolonge la source du transistor T5 lors de la formation de celle-ci, cette source consituant une seule zone N avec la source du transistor T4, le contact avec la connexion 2 étant fait en un point intermédiaire 6; de même la source du transistor T2 et le drain du transistor T5 constituent une seule zone N, et le drain du transistor T4 et la source du transistor T6 constituent une seule zone N.

On réalise également, par dépôt d'aluminium des connexions internes à chaque cellule. Ces connexions internes sont: une connexion reliant l'électrode de grille du transistor T1 à la source du transistor T2 au drain du transistor T5, à l'électrode de grille du transistor T4, et à l'électrode de grille du transistor T5, une connexion reliant l'électrode de grille du transistor T3 à la source du transistor T6 et au drain du transistor T4, et une connexion reliant les sources des transistors T4 et T5 au point intermédiaire 6.

On effectue ensuite un traitement antireflet et passivation des photodiodes par dépôt, sur la couche N correspondante, d'une couche de nitrure de silicium $Si_3 N_4$.

La réalisation de la rétine de photodétecteur est donc simple et ne nécessite que le même nombre de masques, pour l'ensemble des opérations, que dans le cas d'une cellule selon la figure 2, ce qui permet une fabrication économique des rétines et procure un bon rendement de fabrication.

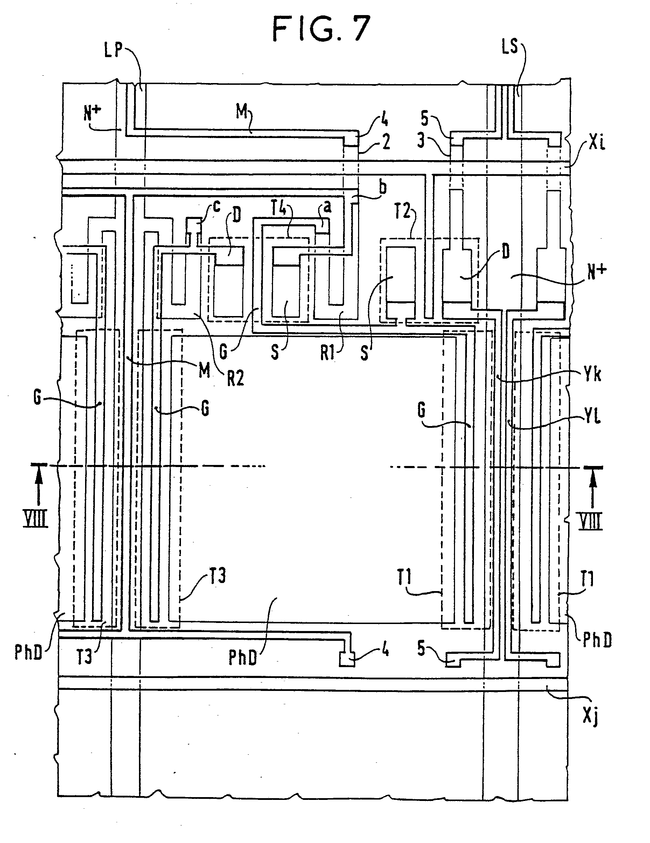

Dans la figure 7, qui représente une deuxième réalisation d'une rétine avec la cellule de la figure 2, la liaison de polarisation LP et la liaison de sortie LS sont réalisées sous forme de barres alternées parallèles; comme chaque liaison est commune à toutes les cellules, les barres de la liaison de polarisation sont donc réunies entre elles, et les barres de la liaison de sortie sont réunies entre elles; ceci est évidemment réalisé lors de l'opération de diffusion de la couche N et ne pose aucun problème de réalisation pour l'homme de l'art. La ligne de masse M est reliée en chaque point 4 à la couche $P^-$ et par celle-ci à la couche $P^+$ du substrat, cette couche $P^+$ constituant la masse de la rétine; les photodiodes étant constituées chacune par une jonction $N/P^-$ sont donc en contact, par la couche $P^-$ avec la couche $P^+$ du substrat. La cellule étant la même que dans la rétine illustrée par la figure 4, sa réalisation est identique.

Les connexions 2 et 3 de la figure 7 sont réalisées par une couche N comme cela a été dit, ceci afin d'assurer la continuité de la liaison d'adressage de ligne par la connexion 5 et de la ligne de masse par la connexion 2 tout en permettant le croisement avec les liaisons d'adressage de colonne. Dans les zones de croisement ces connexions constituent des passage enterrés.

Sur la figure 7 on a représenté deux liaisons d'adressage de ligne Yk et Yl au-dessus de la barre de la liaison de sortie LS de laquelle elles sont isolées par la couche d'oxyde, et une ligne de masse M au-dessus de la liaison de polarisation LP de laquelle elle est isolée par la couche d'oxyde; ceci est justifié par l'implantation des cellules sur le circuit intégré. A partir de la cellule représentée figure 7, l'implantation est la suivante: à droite de la barre de la liaison de sortie LS, on implante une cellule symétrique de celle de la figure 7 par rapport à cette barre; à gauche de la barre de la liaison de polarisation LP, on implante une cellule symétrique de celle de la figure 7 par rapport à cette barre; au-dessus de la liaison d'adressage de colonne Xi, et au-dessous de la liaison d'adressage de colonne Xj, on implante une cellule obtenue par simple glissement de la cellule représentée figure 7. La liaison d'adressage de ligne Yk est donc commune à toutes les cellules situées à gauche de la barre de la liaison de sortie LS et la liaison d'adressage de ligne Yl est commune à toutes les cellules situées à droite de ladite barre. La liaison d'adressage de colonne Xi est commune à toutes les cellules situées en dessous d'elle, la liaison d'adressage de colonne Xj étant commune à toutes les cellules situées en-dessous d'elle.

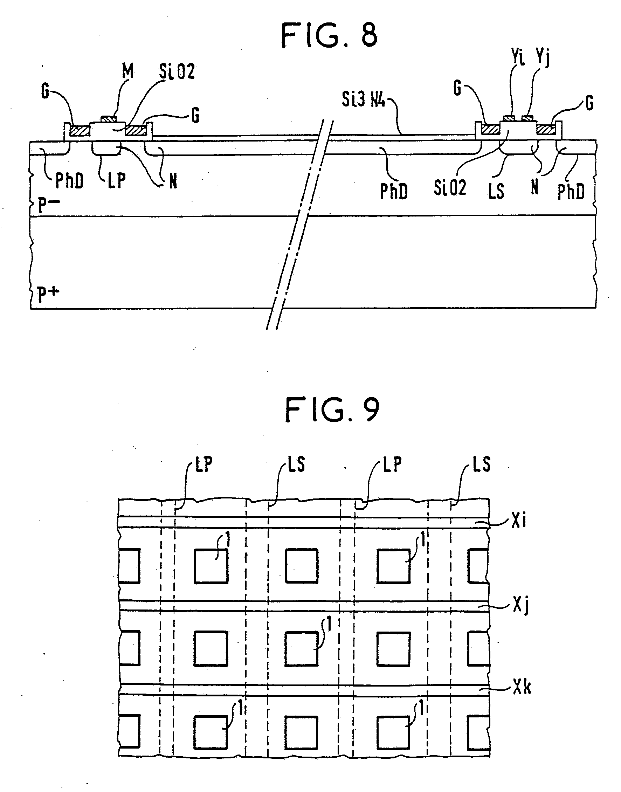

La figure 9 représente schématiquement une partie de la rétine conforme à la figure 7, et montre l'alternance des barres de la liaison de polarisation LP et des barres de la liaison de sortie LS, avec des cellules 1 comprises entre une barre de la liaison de sortie et une barre de la liaison de polarisation; les liaisons d'adressage de ligne ne sont pas représentées sur les barres de la liaison de sortie.

La figure 8 est une vue en coupe selon VIII—VIII de la figure 7, à une échelle agrandie. On y retrouve les zones de type N correspondant aux photodiodes et à la barre de liaison de polarisation LP et à la barre de la liaison de sortie LS; la couche d'oxyde $Si O_2$ au-dessus des barres, porte les métallisation d'aluminium correspondant, au-dessus de la liaison de polarisation LP aux grilles G des transistors T3 et à la ligne de masse M, et au-dessus de la liaison de sortie LS aux grilles des transistors T1 et aux liaisons d'adressage de ligne Yl et Yk. La cellule représentée figure 7 est celle dont le schéma électrique est illustré par la figure 2, sur la quelle on remarque que les sources S des transistors T1 et T3 sont reliées à la cathode de la photodiode PhD, et que les drains D de ces transistors sont reliés à la liaison de sortie LS et à la liaison de polarisation LP, respectivement. La cathode, les sources, les drains et les liaisons de polarisation LP et de sortie LS sont réalisés par une couche N dans la couche $P^-$; aussi afin de limiter le nombre de connexions à réaliser, les sources des transistors T1 et T3 sont elles confondues avec la cathode de la photodiode et les drains sont-ils confondus avec la liaison de sortie pour le transistor T1 et la liaison de polarisation LP pour le transistor T3; il en découple que les sources et drains ne sont pas géométriquement délimités; c'est la raison pour laquelle, sur la figure 7, sources et drains des transistors T1 et T3 ne sont pas représentés, de même sur la figure 8;

on remarque également sur ces figures 7 et 8, que compte tenu de l'implantation de la cellule sur la surface de la rétine qui a été donnée ci-dessus, la liaison de polarisation LP sert de drain pour les transistors T3 situés de part et d'autre de cette liaison, et que la liaison de sortie LS sert de drain pour les transistors T1 situés de part et d'autre de cette liaison. Cette disposition des sources et des drains et des cellules nécessite un masque pour l'opération de diffusion de la couche N, et un masque pour la réalisation des connexions, différents de ceux de la figure 4; elle permet de réduire l'encombrement grâce à l'alternance des barres des liaisons de sortie LS et de polarisation LP.

On a décrit et représenté figures 7 et 8 un exemple de réalisation de la rétine ayant des cellules du type représenté figure 2, c'est-à-dire comportant des résistances R1 et R2. Si l'on veut réaliser une rétine avec la cellule de la figure 3, dans le cas d'une rétine ayant des barres alternées, on réalisera des transistors T5 et T6, comme dans le cas illustré par la figure 10. Dans les différents exemples de réalisation de la rétine, illustrés par les figures 4, 7 et 10, une cellule est toujours implantée entre une barre de la liaison de sortie LS et une barre de la liaison de polarisation LP.

Afin d'ajuster la tension de seuil des transistors T1 à T4 on peut effectuer un surdopage de la couche $P^-$ située au-dessous des grilles de ces transistors; ceci peut être obtenu lors de la réalisation de la couche d'oxyde mince an surdopant celui-ci en bore par exemple; on peut également effectuer un surdopage des régions de la couche $P^-$ correspondant aux grilles des transistors T1 à T4 par implantation ionique à travers un masque spécifique.

La rétine de photodétecteurs de l'invention permet la réception, d'autant de programmes qu'il y a de cellules et la sélection par l'abonné d'un programme parmi ceux reçus; par programme il faut comprendre qu'il peut s'agir de télévision, de données sour forme numérique ou analogique, d'un signal de parole, et d'une manière générale de tout signal sous forme analogique ou numérique.

**Revendications**

1. Rétine de photodétecteurs adressables, sous forme matricielle, comportant une liaison de sortie (LS) commune à tous les photodétecteurs, des liaisons d'adressage de ligne (Yl à Ym), des liaisons d'adressage de colonne (Xl à Xn), chaque photodétecteur étant relié à la masse, et associé à un circuit d'adressage comportant des premiers moyens (T1) pour relier le photodétecteur à la liaison de sortie (LS), caractérisé par le fait que le circuit d'adressage comporte également des deuxièmes moyens (T3) pour relier le photodétecteur à une liaison de polarisation (LP) commune à tous les photodétecteurs et reliée à une source de tension continue, des troisièmes moyens (T4, R2) pour commander les deuxièmes moyens et reliés à la liaison de polarisation (LP) at à la masse, et des quatrièmes moyens (T2, R1) pour commander les premiers et troisièmes moyens, reliés à une liaison d'adressage de ligne (Y), à une liaison d'adressage de colonne (X) et à la masse, les premiers (T1), troisièmes (T4, R2) et quatrièmes (T2, R1) moyens étant bloqués et les deuxièmes moyens (T3) étant passants en l'absence de signal sur les liaisons d'adressage de ligne et de colonne de sorte que le photodétecteur étant illuminé son courant s'écoule par les deuxièmes moyens (T3) et la liaison de polarisation, les premiers, troisièmes et quatrièmes moyens étant passants et les deuxièmes moyens étant bloqués lorsqu'un signal est appliqué sur les liaisons d'adressage de ligne et de colonne pour la sélection du photodétecteur associé au circuit d'adressage, le courant du photodétecteur s'écoulant alors à travers les premiers moyens (T1) dans la liaison de sortie (LS).

2. Rétine de photodétecteurs selon la revendication 1, caractérisée par le fait que les premiers moyens du circuit d'adressage sont constitué par un transistor (T1), que les deuxièmes moyens sont constitués par un transistor (T3), que les troisièmes moyens sont constitués par un transistor (T4) en série avec une résistance (R2) reliée à la liaison de polarisation (LP), un point commun au transistor et à la résistance étant relié à une grille du transistor (T3) des deuxièmes moyens, et que les quatrièmes moyens sont constitués par un transistor (T2) en série avec une résistance (R1) reliée à la masse, le transistor étant relié à la liaison d'adressage de ligne (Y) et ayant une grille reliée à la liaison d'adressage de colonne (X), et un point commun à la résitance et au transistor étant relié à une grille du transistor (T1) des premiers moyens.

3. Rétine de photodétecteurs selon la revendication 1, caractérisée par le fait que les premiers moyens du circuit d'adressage sont constitués par un transistor (T1), que les deuxièmes moyens sont constitués par un transistor (T3), que les troisièmes moyens sont constitués par un premier (T4) et un deuxième (T6) transistors en série le deuxième transistor (T6) étant relié à la liaison de polarisation (LP) et ayant une grille reliée également à la liaison de polarisation (LP), un point commun aux premier et deuxième transistors étant relié à une grille du transistor (T3) des deuxièmes moyens, et que les quatrièmes moyens sont constitués par un premier (T2) et un deuxième (T5) transistors en série, le deuxième transistor (T5) étant relié à la masse et ayant une grille reliée au premier transistor (T2) le premier transistor (T2) étant relié à la liaison d'adressage de ligne (Y) et ayant une grille reliée à la liaison d'adressage de colonne (X), un point commun aux premier et deuxième transistors étant relié à une grille du transistor (T1) des premiers moyens.

4. Rétine de photodétecteurs selon la revendication 2, caractérisée par le fait que l'on forme, sur toute une surface d'une pastille d'un substrat de type $P^+$ à faible résistivité, une couche de type $P^-$ à forte résistivité, que l'on forme dans la couche à forte résistivité des zones de type N pour constituer d'une part avec la couche P⁻ à forte résistivité des jonctions correspondant aux photodétecteurs (PhD), aux sources (S) et aux drains (D) des transistors (T2, T4) des troisièmes et quatrièmes moyens, et d'autre part les résistances (R1, R2), une extrémité de la résistance (R1) des quatrièmes moyens étant en contact avec la liaison de polarisation, des premières connexions (2) prolongeant chacune la résistance (R1) des quatrièmes moyens, des deuxièmes connexions (3) prolongeant chacune le drain du transistor (T2) des quatrièmes moyens, la liaison de sortie (LS) et la liaison de polarisation (LP) sour forme de barres une barre de la liaison de sortie et une barre de la liaison de polarisation étant placées côté à côte et constituant un jeu de barres la rétine comportant plusieurs jeux de barres parallèles et chaque photodétecteur (PhD) ainsi que les transistors (T2, T4) et les résistances (R1, R2) des troisièmes et quatrièmes moyens de son circuit d'adressage, et la première et la deuxième connexion (2, 3), reliées à son circuit d'adressage étant situés entre deux jeux de barres, les sources et drains des transistors (T1) des premiers moyens étant respectivement communs aux photodétecteurs et à la liaison de sortie (LS), les sources et drains des transistors (T3) des deuxièmes moyens étant respectivement communs aux photodétecteurs et à la liaison de polarisations (LP), que l'on recouvre la surface de la pastille, à l'exception des photodétecteurs, et d'une partie des sources et des drains des transistors (T2, T4) des troisièmes et quatrièmes moyens, d'une couche d'oxyde mince (Si O₂), que l'on effectue dans la couche d'oxyde des ouvertures de contacts à une extrémité (5) de chacune des deuxièmes connexions (3) opposée au drain qu'elle prolonge, à chaque extrémité (c) des résistances (R2) des troisièmes moyens et à chaque extrémité (b) des résistances (R1) des quatrièmes moyens, pour accéder à la couche N, et à une extrémité (4) de chacune des premières connexions (2) opposée à la résistance (R1) qu'elle prolonge, pour accéder à la couche P⁻ de forte résistivité, que l'on réalise, par dépôt d'un métal bon conducteur de l'électricité, des électrodes des sources et drains des transistors (T2, T4) des troisièmes et quatrièmes moyens, dans les parties non recouvertes d'oxyde, des contacts avec les couches N et P⁻ dans les ouvertures de contact, et sur l'oxyde, des électrodes des grilles des transistors (T1 à T4) et un réseau d'interconnexion constitué par les liaisons d'adressage de colonne (XI à Xn) et des connexions de celles ci avec les électrodes de grille des transistors (T2) des quatrièmes moyens, les liaisons d'adressage de ligne (YI à Ym) au dessus des barres de la liaison de sortie (LS), chaque barre comportant une liaison d'adressage de ligne, et des connexions de celles-ci avec les drains des transistors (T2) des quatrièmes moyens et les extrémités (5) des deuxièmes connexions (3), une ligne de masse (M) au dessus des barres de la liaison de polarisations (LP) et des connexions de celle-ci avec les résistances (R1) des quatrièmes moyens et les extrémités (4) des premières connexions (2), et des connexions internes à chaque circuit d'adressage, que l'on dépose en surface des photodétecteurs une couche antireflet, et que la rétine est constituée de cellules se déduisant les unes des autres par glissement vertical et par glissement horizontal, chaque cellule comportant un photodétecteur et son circuit d'adressage.

5. Rétine de photodétecteurs selon la revendication 3, caractérisée par le fait que l'on forme sur toute une surface d'une pastille d'un substrat de type P⁺ à faible résistivité une couche de type P⁻ à forte résistivité, que l'on forme dans la couche à forte résistivité des zones de type N pour constituer d'une part avec la couche P⁻ à forte résistivité des jonctions correspondant aux photodétecteurs (PhD), aux sources (S) et aux drains (D) des transistors (T2, T4, T5, T6) des troisièmes et quatrièmes moyens, le drain du deuxième transistor (T6) des troisièmes moyens étant en contact avec la liaison de polarisation, et d'autre part des premières connexions (2) prolongeant chacune la source du deuxième transistor (T5) des quatrièmes moyens, des deuxièmes connexions (3) prolongeant chacune le drain du premier transistor (T2) des quatrièmes moyens, la liaison de sortie (LS) et la liaison de polarisation (LP) sous forme de barres, une barre de la liaison de sortie et une barre de la liaison de polarisation étant placées côte à côte et constituant un jeu de barres, la rétine comportant plusieurs jeux de barres parallèles et chaque photodétecteur (PhD), ainsi que les transistors (T2, T4, T5, T6) des troisièmes et quatrièmes moyens de son circuit d'adressage et la première et la deuxième connexion (2, 3) reliées à son circuit d'adressage étant situés entre deux jeux de barres, les sources et drains des transistors (T1) des premiers moyens étant respectivement communs aux photodétecteurs et à la liaison de sortie (LS), les sources et drains des transistors (T3) des deuxièmes moyens étant respectivement communs aux photodétecteurs et à la liaison de polarisation (LP), que l'on recouvre la surface de la pastille, à l'exception des photodétecteurs et d'une partie des sources et des drains des transistors (T2, T4, T5, T6) des troisièmes et quatrièmes moyens, d'une couche d'oxyde mince (Si O₂), que l'on effectue dans la couche d'oxyde des ouvertures de contacts à une extrémité (5) de chacune des deuxièmes connexions (3) opposée au drain qu'elle prolonge et en un point intermédiaire (6) de chacune des premières connexions (2), pour accéder à la couche N, et à une extrémité (4) de chacune des premières connexions (2) opposée à la source qu'elle prolonge, pour accéder à la couche P⁻ de forte résistivité, que l'on réalise, par dépôt d'un métal bon conducteur de l'électricité, des électrodes des sources et drains des transistors (T2, T4, T5, T6) des troisièmes et quatrièmes moyens dans les parties non recouvertes d'oxyde, des contacts avec les couches N et P⁻ dans les ouvertures de contact, et sur l'oxyde, des électrodes des grilles des transistors (T1 à T4) et un réseau d'interconnexion constitué par les liaisons d'adressage de colonne (XI à Xn) et des connexions de celles-ci avec les électrodes de grille des premiers transistors (T2) des quatrièmes moyens, les liaisons d'adressage de ligne (YI à Ym) au dessus des barres de la liaison de sortie (LS) chaque barre comportant une liaison d'adressage de ligne, et des connexions de celles-ci avec les drains des premiers transistors (T2) des quatrièmes moyens et les extrémités (5) des deuxièmes connexions (3), une ligne de masse (M) au dessus de la liaison de polarisation (LP) et des connexions de celle-ci avec les sources des deuxièmes transistors (T5) des quatrièmes moyens, le point intermédiaire (6) et les extrémités (4) des premières connexions (2), et des connexions internes à chaque circuit d'adressage, que l'on dépose en surface des photodétecteurs une couche antireflet, et que la rétine est constituée de cellules se déduisant les unes des autres par glissement vertical et horizontal, chaque cellule comportant un photodétecteur et son circuit d'adressage.

6. Rétine de photodétecteurs selon la revendication 2, caractérisée par le fait que l'on forme, sur toute une surface d'une pastille d'un substrat de type P$^+$ à faible résistivité, une couche de type P$^-$ à forte résistivité, que l'on forme dans la couche à forte résistivité des zones de type N pour constituer d'une part avec la couche P$^-$ à forte résistivité des jonctions correspondant aux photodétecteurs (PhD), aux sources (S) et aux drains (D) des transistors (T2, T4) des troisièmes et quatrièmes moyens, et d'autre part les résistances (R1, R2), une extrémité de la résistance (R1) des quatrièmes moyens étant en contact avec la liaison de polarisation, des premières connexions (2) prolongeant chacune la résistance (R1) des quatrièmes moyens, des deuxièmes connexions (3) prolongeant chacune le drain du transistor (T2) des quatrièmes moyens, la liaison de sortie (LS) et la liaison de polarisation (LP) sous forme de barres alternées, la rétine comportant plusieurs barres alternées et chaque photodétecteur (PhD) ainsi que les transistors (T2, T4), et les résistances (R1, R2) des troisièmes et quatrièmes moyens, et la première et la deuxième connexion (2, 3) reliées à son circuit d'adressage étant situés entre deux barres alternées, les sources et drains des transistors (T1) des premiers moyens étant respectivement communs aux photodétecteurs et à la liaison de sortie (LS), les sources et drains des transistors (T3) des deuxièmes moyens étant respectivement communs aux photodétecteurs et à la liaison de polarisation (LP), que l'on recouvre la surface de la pastille, à l'exception des photodétecteurs et une partie des sources et des drains des transistors (T2, T4) des troisièmes et quatrièmes moyens, d'une couche d'oxyde mince (Si O$_2$), que l'on effectue dans la couche d'oxyde des ouvertures de contacts à une extrémité (5) de chacune des deuxièmes connexions (3) opposée au drain qu'elle prolonge, à chaque extrémité (c) des résistances (R2) des troisièmes moyens, et à chaque extrémité (b) des résistances (R1) des quatrièmes moyens, pour accéder à la couche N, et à une extrémité (4) de chacune des premières connexions (2) opposée à la résistance (R1) qu'elle prolonge, pour accéder à la couche P$^-$ de forte résistivité, que l'on réalisé, par dépôt d'un métal bon conducteur de l'électricité, des électrodes des sources et drains des transistors (T2, T4) des troisièmes et quatrièmes moyens dans les parties non recouvertes d'oxyde, des contacts avec les couches N et P$^-$ dans les ouvertures de contact, et sur l'oxyde, des électrodes des grilles des transistors (T1 à T4) et une réseau d'interconnexion constitué par les liaisons d'adressage de colonne (XI à Xn), et des connexions de celles-ci avec les électrodes de grille des transistors (T2) des quatrièmes moyens, les liaisons d'adressage de ligne (YI à Ym) au dessus des barres de la liaison de sortie (LS) chaque barre comportant deux liaisons d'adressage de lignes affectées chacune à un circuit d'adressage différent situé de chaque côté de ladite barre, et des connexions de celles-ci avec les drains des transistors (T2) des quatrièmes moyens et les extrémités (5) des deuxièmes connexions (3), une ligne de masse (M), au dessus des barres de la liaison de polarisation (LP), et des connexions de celle-ci avec l'extrémité (b) des résistances (R1) des quatrièmes moyens et les extrémités (4) des premières connexions (2), et des connexions internes à chaque circuit d'adressage, que l'on dépose en surface des photodétecteurs une couche antireflet, et que la rétine est constituée de cellules qui entre deux barres alternées se déduisent l'une de l'autre par glissement vertical, et qui horizontalement se déduisent l'une de l'autre par symétrie, d'un côté par rapport à une barre de la liaison de sortie et d'un autre côté par rapport à une barre de la liaison de polarisation, une cellule comportant un photodétecteur et son circuit d'adressage.

7. Rétine de photodétecteurs selon la revendication 3, caractérisée par le fait que l'on forme sur toute une surface d'une pastille d'un substrat de type P$^+$ à faible résistivité une couche de type P$^-$ à forte résistivité, que l'on forme dans la couche à forte résistivité des zones de type N pour constituer d'une part avec la couche P$^-$ à forte résistivité des jontions correspondant aux photodétecteurs (PhD), aux sources (S) et aux drains (D) des transistors (T2, T4, T5, T6) des troisièmes et quatrièmes moyens, le drain du deuxième transistor (T6) des troisièmes moyens étant en contact avec la liaison de polarisation, et d'autre part des premières connexions (2) prolongeant chacune la source du deuxième transistor (T5) des quatrièmes moyens, des deuxièmes connexions (3) prolongeant chacune le drain du premier transistor (T2) des quatrièmes moyens, la liaison de sortie (LS) et la liaison de polarisation (LP) sous fource de barres alternées, la rétine comportant plusieurs barres alternées et chaque photodétecteur (PhD) ainsi que les transistors (T2, T4, T5, T6) des troisièmes et quatrièmes moyens de son circuit d'adressage et la première et la deuxième connexion, (2, 3) reliées à son circuit d'adressage étant situés entre deux barres alternées, les sources et drains des transistors (T1) des premiers moyens étant respectivement communs aux photodétecteurs et à la liaison de sortie (LS), les sources et drains des transistors (T3) des deuxièmes moyens étant respectivement communs aux photodétecteurs et à la liaison de polarisation (LP), que l'on recouvre la surface de la pastille, à l'exception des photodétecteurs et d'une partie des sources et des drains des transistors (T2, T4, T5, T6) des troisièmes et quatrièmes moyens, d'une couche d'oxyde mince (Si O$_2$), que l'on effectue dans la couche d'oxyde des ouvertures de contacts à une extrémité (5) de chacune des deuxièmes connexions (3) opposée au drain qu'elle prolonge et en un point intermédiaire (6) de chacune des premières connexions (2), pour accéder à la couche N, et à une extrémité (4) de chacune des premières connexions (2) opposée à la source qu'elle prolonge, pour accéder à la couche P$^-$ de forte résistivité, que l'on réalise, par dépôt d'un métal bon conducteur de l'électricité, des électrodes des sources et drains des transistors (T2, T4, T5, T6) des troisièmes et quatrièmes moyens dans les parties non recouvertes d'oxyde, des contacts avec les couches N et P$^-$ dans les ouvertures de contact, et sur l'oxyde, des électrodes de grilles des transistors (T1 à T4) et un réseau d'interconnexion constitué par les liaisons d'adressage de colonne (XI à Xn) et des connexions de celles-ci avec les électrodes de grille des premiers transitors (T2) des quatrièmes moyens, les liaisons d'adressage de ligne (YI à Ym) au dessus des barres de la liaison de sortie (LS), chaque barre comportant deux liaisons d'adressage de lignes affectées chacune à un circuit d'adressage différent situé de chaque côté de ladite barre, et des connexions de celles-ci avec les drains des premiers transistors (T2) des quatrièmes moyens et les extrémités (5) des deuxièmes connexions (3), une ligne de masse (M) au dessus de la liaison de polarisation et des connexions de celle-ci avec les sources des deuxièmes transistors (T5) des quatrièmes moyens, le point intermédiaire (6) et les extrémités (4) des premières connexions (2), et des connexions internes à chaque circuit d'adressage, et que l'on dépose en surface des photodétecteurs une couche antireflet, que la rétine est constituée de cellules qui entre deux barres alternées se déduisent l'une de l'autre par glissement vertical, et qui horizontalement se déduisent l'une de l'autre par symétrie d'un côté par rapport à une barre de la liaison de sortie et d'autre part par rapport à une barre de la liaison de polarisation, une cellule comportant un photodétecteur et son circuit d'adressage.

## Patentansprüche

1. Matrixartiges Netz von adressierbaren Fotodetektoren, mit einer allen Fotodetektoren gemeinsamen Ausgangsleitung (LS), mit Zeilenadressierleitungen (YI bis Ym), mit Spaltenadressierleitungen (XI bis Xn), wobei jeder Fotodetektor an Masse angeschlossen ist und einem Adressierkreis zugeordnet ist, der erste Mittel (T1) zum Anschluß der Fotodetektoren an die Ausgangsleitung (LS) aufweist, dadurch gekennzeichnet, daß der Adressierkreis auch zweite Mittel (T3) zum Anschluß des Fotodetektors an eine allen Fotodetektoren gemeinsame Vorspannungsleitung (LP), die an eine Gleichspannungsquelle angeschlossen ist, dritte Mittel (T4, R2), die zur Steuerung der zweiten Mittel bestimmt sind und an die Vorspannungsleitung (LP) und an Masse angeschlossen sind, und vierte Mittel (T2, R1) aufweist, die zur Steuerung der ersten und dritten Mittel bestimmt sind und an eine Zeilenadressierleitung (Y), eine Spaltenadressierleitung (X) und an Masse angeschlossen sind, wobei die ersten (T1), dritten (T4, R2) und vierten Mittel (T2, R1) gesperrt und die zweiten Mittel (T3) durchlässig sind, wenn auf der Zeilen- und der Spaltenadressierleitung kein Signal vorliegt, so daß der Strom des einen Lichtstrahl empfangenden Fotodetektors über die zweiten Mittel (T3) und die Vorspannungsleitung fließt, während die ersten, dritten und vierten Mittel durchlässig und die zweiten Mittel gesperrt sind, wenn ein Signal an die Zeilen- und Spaltenadressierleitungen zur Auswahl des dem Adressierkreis zugeordneten Fotodetektors angelegt wird, wobei dann der Strom des Fotodetektors durch die ersten Mittel (T1) in die Ausgangsleitung (LS) fließt.

2. Netz von Fotodetektoren nach Anspruch 1, dadurch gekennzeichnet, daß die ersten Mittel des Adressierkreises aus einem Transistor (T1) bestehen, daß die zweiten Mittel aus einem Transistor (T3) bestehen, daß die dritten Mittel aus einem Transistor (T4) in Reihe mit einem Widerstand (R2) bestehen, der an die Vorspannungsleitung (LP) angeschlossen ist, wobei der Verbindungspunkt zwischen dem Transistor und dem Widerstand an ein Gate des Transistors (T3) der zweiten Mittel angeschlossen ist, und daß die vierten Mittel aus einem Transistor (T2) in Reihe mit einem an Masse liegenden Widerstand (R1) bestehen, wobei der Transistor an die Zeilenadressierleitung (Y) und mit einem Gate an die Spaltenadressierleitung (X) angeschlossen ist, während ein Punkt zwischen dem Widerstand und dem Transistor an ein Gate des Transistors (T1) der ersten Mittel angeschlossen ist.

3. Netz von Fotodetektoren nach Anspruch 1, dadurch gekennzeichnet, daß die ersten Mittel des Adressierkreises aus einem Transistor (T1) bestehen, daß die zweiten Mittel aus einem Transistor (T3) bestehen, daß die dritten Mittel aus einem ersten (T4) und einem zweiten Transistor (T6) in Reihe bestehen, wobei der zweite Transistor (T6) an die Vorspannungsleitung (LP) angeschlossen ist, und mit seinem Gate ebenfalls an die Vorspannungsleitung (LP) angeschlossen ist, wobei ein dem ersten und zweiten Transistors gemeinsamer Punkt an ein Gate des Transistors (T3) der zweiten Mittel angeschlossen ist, und daß die vierten Mittel aus einem ersten (T2) und einem zweiten Transistor (T5) in Reihenschaltung bestehen, wobei letzterer (T5) an Masse liegt und mit einem Gate an den ersten Transistor (T2) angeschlossen ist, während der erste Transistor (T2) an die Zeilenadressierleitung (Y) und mit einem Gate an die Spaltenadressierleitung (X) angeschlossen ist, wobei ein dem ersten und zweiten Transistor gemeinsamer Punkt an ein Gate des transistors (T1) der ersten Mittel angeschlossen ist.

4. Netz von Fotodetektoren nach Anspruch 2, dadurch gekennzeichnet, daß man auf der ganzen Oberfläche eines Substratplättchens vom Typ P$^+$ mit einem niedrigen spezifischen Widerstand eine Schicht vom Typ P$^-$ mit großem spezifischem Widerstand ausbildet, daß in der Schicht mit großem spezifischem Widerstand Zonen vom Typ N ausgebildet werden, die einerseits mit der Schicht vom Typ P$^-$ großen spezifischen Widerstands den Fotodetektoren (PhD), den Quellenelektroden (S) und den Drainelektroden (D) der Transistoren (T2, T4) der dritten und vierten Mittel entsprechende Verbindungen und andererseits die Widerstände (R1, R2) bilden, wobei ein Ende des Widerstands (R1), der vierten Mittel in Kontakt mit der Vorspannungsleitung ist, und erste Anschlüsse (2) je den Widerstand (R1) der vierten Mittel verlängern, während zweite Anschlüsse (3) je die Drainelektrode des Transistors (T2) der vierten Mittel, die Ausgangsleitung (LS) und die Vorspannungsleitung (LP) in Form von Schienen verlängern, wobei eine Schiene der Ausgangsleitung und eine Schiene der Vorspannungsleitung nebeneinanderliegen und einen Schienensatz bilden, wobei das Netz mehrere parallele Schienensätze aufweist und jeder Fotodetektor (PhD) sowie die Transistoren (T2, T4) und die Widerstände (R1, R2) der dritten und vierten Mittel seines Adressierkreises sowie die ersten und zweiten Anschlüsse (2, 3), die an seinen Adressierkreis angeschlossen sind, zwischen zwei Sätzen von Schienen liegen, wobei die Quellen- und Drainelektroden der Transistoren (T1) der ersten Mittel für die Fotodetektoren bzw. die Ausgangsleitung (LS) gemeinsam sind, die Quellen- und Drainelektroden der Transistoren (T3) der zweiten Mittel den Fotodetektoren bzw. der Vorspannungsleitung (LP) gemeinsam sind, daß die Oberfläche des Plättchens mit Ausnahme der Fotodetektoren und eines Bereichs der Quellen- und Drainelektroden der Transistor (T2, T4) der dritten und vierten Mittel mit einer dünnen Oxidschicht (SiO$_2$) bedeckt ist, daß man in der Oxidschicht Öffnungen zur Kontaktierung vorsieht, und zwar an einem der sie verlängernden Drainelektrode entgegengesetzten Ende (5) jedes der zweiten Anschlüsse (3), an jedem Ende (c) der Widerstände (R2) der dritten Mittel und an jedem Ende (b) der Widerstände (R1) der vierten Mittel, um Zugang zur Schicht N zu bekommen, und an einem Ende (4) jedes der dem Widerstand (R1), den er verlängert, entgegengesetzten ersten Anschlüsse (2) des Widerstands (R1), um Zugang zur Schicht vom Typ P$^-$ großen spezifischen Widerstands zu bekommen, daß man durch Aufbringen einer die Elektrizität gut leitenden Metallschicht Quellen- und Drainelektroden der Transistoren (T2, T4) der dritten und vierten Mittel in den nicht mit der Oxidschicht bedeckten Bereichen, Kontakte mit den Schichten vom Typ N und P$^-$ in den Kontaktöffnungen, und auf der Oxidschicht Gateelektroden der Transistoren (T1 bis T4) sowie ein Verbindungsnetzwerk herstellt, das aus den Spaltenadressierleitungen (XI bis Xn) und Anschlüssen dieser Leitungen an die Gateelektroden der Transistoren (T2) der vierten Mittel, aus den Zeilenadressierleitungen (YI bis Ym) oberhalb der Schienen der Ausgangsleitung (LS), wobei jede Schiene eine Zeilenadressierleitung aufweist, und aus Anschlüssen dieser Leitungen an die Drainelektroden der Transistoren (T2) der vierten Mittel und an die Enden (5) der zweiten Anschlüsse (3), sowie aus einer Masseleitung (M) oberhalb der Schienen der Vorspannungsleitung (LP) und aus Anschlüssen dieser Leitung an die Widerstände (R1) der vierten Mittel und an die Enden (4) der ersten Anschlüsse (2), und aus Anschlüssen besteht, die innerhalb jedes Adressierkreises verlaufen, daß auf die Oberfläche der Fotodetektoren eine Antireflexschicht aufgebracht ist und daß das Netz aus Zellen besteht, die sich durch senkrechte und waagerrechte Verschiebung voneinander ableiten lassen, wobei jede Zelle einen Fotodetektor und seinen Adressierkreis enthält.

5. Netz von Fotodetektoren nach Anspruch 3, dadurch gekennzeichnet, daß man auf der ganzen Oberfläche eines Substratplättchens vom Typ P$^+$ mit einem niedrigen spezifischen Widerstand eine Schicht vom Typ P$^-$ mit großem spezifischem Widerstand ausbildet, daß in der Schicht mit großem spezifischem Widerstand Zonen vom Typ N ausgebildet werden, die einerseits mit der Schicht vom Typ P$^-$ großen spezifischen Widerstands den Fotodetektoren (PhD), den Quellenelektroden (S) und den Drainelektroden (D) der Transistoren (T2, T4, T5, T6) der dritten und vierten Mittel entsprechende Verbindungen, wobei die Drainelektrode des zweiten Transistors (T6) der dritten Mittel mit der Vorspannungsleitung in Kontakt steht, und andererseits erste Anschlüsse (2) bilden, die je die Quellenelektrode des zweiten Transistors (T5) der vierten Mittel verlängern, während zweite Anschlüsse (3) je die Drainelektrode des ersten Transistors (T2) der vierten Mittel, die Ausgangsleitung (LS) und die Vorspannungsleitung (LP) in Form von Schienen verlängern, wobei eine Schiene der Ausgangsleitung und eine Schiene der Vorspannungsleitung nebeneinanderliegen und einen Schienensatz bilden, wobei das Netz mehrere parallele Schienensätze aufweist und jeder Fotodetektor (PhD) sowie die Transistoren (T2, T4, T5, T6) der dritten und vierten Mittel seines Adressierkreises sowie die ersten und zweiten Anschlüsse (2, 3), die an seinen Adressierkreis angeschlossen sind, zwischen zwei Sätzen von Schienen liegen, wobei die Quellen- und Drainelektroden der Transistoren (T1) der ersten Mittel für die Fotodetektoren bzw. die Ausgangsleitung (LS) gemeinsam sind, die Quellen- und Drainelektroden der Transistoren (T3) der zweiten Mittel den Fotodetektoren bzw. der Vorspannungsleitung (LP) gemeinsam sind, daß die Oberfläche des Plättchens mit Ausnahme der Fotodetektoren und eines Bereichs der Quellen- und Drainelektroden der Transistoren (T2, T4) der dritten und vierten Mittel mit einer dünnen Oxidschicht (SiO$_2$) bedeckt ist, daß man in der Oxidschicht Öffnungen zur Kontaktierung vorsieht, und zwar an einem der sie verlängernden Drainelektrode entgegengesetzten Ende (5) jedes der zweiten Anschlüsse (3), und an einem Zwischenpunkt (6) jedes der ersten Anschlüsse (2), um Zugang zur Schicht N zu bekommen, un an einem Ende (4) jedes der die Quellenelektrode, die er verlängert, entgegengesetzten ersten Anschlüsse (2), um Zugang zur Schicht vom Typ P$^-$ großen spezifischen Widerstands zu bekommen, daß man durch Aufbringen einer die Elektrizität gut leitenden Metallschicht Quellen- und Drainelektroden der Transistoren (T2, T4, T5, T6) der dritten und vierten Mittel in den nicht mit der Oxidschicht bedeckten Bereichen, Kontakte mit den Schichten vom Typ N und P$^-$ in den Kontaktöffnungen, und auf der Oxidschicht Gateelektroden der Transistoren (T1 bis T4) sowie ein Verbindungsnetzwerk herstellt, das aus den Spaltenadressierleitungen (Xl bis Xn) und Anschlüssen dieser Leitungen an die Gateelektroden der ersten Transistoren (T2) der vierten Mittel, aus den Zeilenadressierleitungen (Yl bis Ym) oberhalb der Schienen der Ausgangsleitung (LS), wobei jede Schiene eine Zeilenadressierleitung aufweist, und aus Anschlüssen dieser Leitungen an die Drainelektroden der ersten Transistoren (T2) der vierten Mittel und an die Enden (5) der zweiten Anschlüsse (3), sowie aus einer Masseleitung (M) oberhalb der Vorspannungsleitung (LP) und aus Anschlüssen dieser Leitung an die Quellenelektroden der zweiten Transistoren (T5) der vierten Mittel, aus dem Zwischenpunkt (6) und den Enden (4) der ersten Anschlüsse (2), und aus Anschlüssen besteht, die innerhalb jedes Adressierkreises verlaufen, daß auf die Oberfläche der Fotodetektoren eine Antireflexschicht aufgebracht ist und daß das Netz aus Zellen besteht, die sich durch senkrechte und waagerechte Verschiebung voneinander ableiten lassen, wobei jede Zelle einen Fotodetektor und seinen Adressierkreis enthält.

6. Netz von Fotodetektoren nach Anspruch 2, dadurch gekennzeichnet, daß man auf der ganzen Oberfläche eines Substratplättchens vom Typ P$^+$ mit einem niedrigen spezifischen Widerstand eine Schicht vom Typ P$^-$ mit großem spezifischem Widerstand ausbildet, daß in der Schicht mit großem spezifischem Widerstand Zonen vom Typ N ausgebildet werden, die einerseits mit der Schicht vom Typ P$^-$ großen spezifischen Widerstands den Fotodetektoren (PhD), den Quellenelektroden (S) und den Drainelektroden (D) der Transistoren (T2, T4) der dritten und vierten Mittel entsprechende Verbindungen, und andererseits die Widerstände (R1, R2) bilden, wobei ein Ende des Widerstands (R1) der vierten Mittel in Kontakt mit der Vorspannungsleitung ist, und erste Anschlüsse (2) je den Widerstand (R1) der vierten Mittel verlängern, während zweite Anschlüsse (3) je die Drainelektrode des Transistors (T2) der vierten Mittel, die Ausgangsleitung (LS) und die Vorspannungsleitung (LP) in Form von abwechselnden Schienen verlängern, wobei das Netz mehrere abwechselnde Schienen aufweist und jeder Fotodetektor (PhD) sowie die Transistoren (T2, T4) und die Widerstände (R1, R2) der dritten und vierten Mittel sowie die ersten und zweiten Anschlüsse (2, 3), die an seinen Adressierkreis angeschlossen sind, zwischen zwei abwechselnden Schienen liegen, wobei die Quellen- und Drainelektroden der Transistoren (T1) der ersten Mittel für die Fotodetektoren bzw. die Ausgangsleitung (LS) gemeinsam sind, die Quellen- und Drainelektroden der Transistoren (T3) der zweiten Mittel den Fotodetektoren bzw. der Vorspannungsleitung (LP) gemeinsam sind, daß die Oberfläche des Plättchens mit Ausnahme der Fotodetektoren und eines Bereichs der Quellen- und Drainelektroden der Transistoren (T2, T4) der dritten und vierten Mittel mit einer dünnen Oxidschicht (SiO$_2$) bedeckt ist, daß man in der Oxidschicht Öffnungen zur Kontaktierung vorsieht, und zwar an einem der sie verlängernden Drainelektrode entgegengesetzten Ende (5) jedes der zweiten Anschlüsse (3), an jedem Ende (c) der Widerstände (R2) der dritten Mittel und an jedem Ende (b) der Widerstände (R1) der vierten Mittel, um Zugang zur Schicht N zu bekommen, und an einem Ende (4) jedes der dem Widerstand (R1), den er verlängert, entgegengesetzten ersten Anschlüsse (2), um Zugang zur Schicht vom Typ P$^-$ großen spezifischen Widerstands zu bekommen, daß man durch Aufbringen einer die Elektrizität gut leitenden Metallschicht Quellen- und Drainelektroden der Transistoren (T2, T4) der dritten und vierten Mittel in den nicht mit der Oxidschicht bedeckten Bereichen, Kontakte mit den Schichten vom Typ N und P$^-$ in den Kontaktstöffnungen, und auf der Oxidschicht Gateelektroden der Transistoren (T1 bis T4) sowie ein Verbindungsnetzwerk herstellt, das aus den Spaltenadressierleitungen (Xl bis Xn) und Anschlüssen dieser Leitungen an die Gateelektroden der Transistoren (T2) der vierten Mittel, aus den Zeilenadressierleitungen (Yl bis Ym) oberhalb der Schienen der Ausgangsleitung (LS), wobei jede Schiene zwei Zeilenadressierleitungen aufweist, die je einem anderen auf jeder Seite der Schiene liegenden Adressierkreis zugeordnet sind, und aus Anschlüssen dieser Leitungen an die Drainelektroden der Transistoren (T2) der vierten Mittel und an die Enden (5) der zweiten Anschlüsse (3), sowie aus einer Masseleitung (M) oberhalb der Schienen der Vorspannungsleitung (LP) und aus Anschlüssen dieser Leitung an das Ende (b) der Widerstände (R1) der vierten Mittel und an die Enden (4) der ersten Anschlüsse (2), und aus Anschlüssen besteht, die innerhalb jedes Adressierkreises verlaufen, daß auf die Oberfläche der Fotodetektoren eine Antireflexschicht aufgebracht ist und daß das Netz aus Zellen besteht, die sich zwischen zwei abwechselnden Schienen durch senkrechte Verschiebung voneinander ableiten lassen, während sie sich horizontal voneinander mittels Symmetrie ableiten lassen, und zwar einerseits bezüglich einer Schiene der Ausgangsleitung und andererseits bezüglich einer Schiene der Vorspannungsleitung, wobei eine Zelle einen Fotodetektor und seinen Adressierkreis enthält.

7. Netz von Fotodetektoren nach Anspruch 3, dadurch gekennzeichnet, daß man auf der ganzen Oberfläche eines Substratplättchens vom Typ P⁺ mit einem niedrigen spezifischen Widerstand eine Schicht vom Typ P⁻ mit großem spezifischen Widerstand ausbildet, daß in der Schicht mit großem spezifischem Widerstand Zonen vom Typ ausgebildet werden, die einerseits mit der Schicht vom Typ P⁻ großen spezifischen Widerstands den Fotodetektoren (PhD), den Quellenelektroden (S) und den Drainelektroden (D) der Transistoren (T2, T4, T5, T6) der dritten und vierten Mittel entsprechende Verbindungen, wobei die Drainelektrode des zweiten Transistors (T6) der dritten Mittel mit der vorspannungsleitung in Kontakt steht, und andererseits erste Anschlüsse (2) bilden, die je die Quellenelektrode des zweiten Transistors (T5) der vierten Mittel verlängern, während zweite Anschlüsse (3) je die Drainelektrode des ersten Transistors (T2) der vierten Mittel, die Ausgangsleitung (LS) und die Vorspannungsleitung (LP) in Form von abwechselnden Schienen verlängern, wobei das Netz mehrere abwechselnde Schienen aufweist und jeder Fotodetektor (PhD) sowie die Transistoren (T2, T4, T5, T6) der dritten und vierten Mittel seines Adressierkreises sowie die ersten und zweiten Anschlüs-se (2, 3), die an seinen Adressierkreis angeschlossen sind, zwischen zwei abwechselnden Leisten liegen, wobei die Quellen- und Drainelektroden der Transistoren (T1) der ersten Mittel für die Fotodetektoren bzw. die Ausgangsleitung (LS) gemeinsam sind, die Quellen- und Drainelektroden der Transistoren (T3) der zweiten Mittel den Fotodetektoren bzw. der Vorspannungsleitung (LP) gemeinsam sind, daß die Oberfläche des Plättchens mit Ausnahme der Fotodetektoren und eines Bereichs der Quellen- und Drainelektroden der Transistoren (T2, T4, T5, T6) der dritten und vierten Mittel mit einer dünnen Oxidschicht (SiO₂) bedeckt ist, daß man in der Oxidschicht Öffnungen zur Kontaktierung vorsieht, und zwar an einem der sie verlängernden Drainelektrode entgegengesetzten Ende (5) jedes der zweiten Anschlüsse (3), und an einem Zwischenpunkt (6) jedes der ersten Anschlüsse (2), um Zugang zur Schicht N zu bekommen, und an einem Ende (4) jeder der ihn verlängernden der Quellenelektrode gegenüberliegenden ersten Anschlüsse (2), um Zugang zur Schicht vom Typ P⁻ großen spezifischen Widerstands zu bekommen, daß man durch Aufbringen einer die Elektrizität gut leitenden Metallschicht Quellen- und Drainelektroden der Transistoren (T2, T4, T5, T6) der dritten und vierten Mittel in den nicht mit der Oxidschicht bedeckten Bereichen, Kontakte mit den Schichten vom Typ N und P⁻ in den Kontaktöffnungen, und auf der Oxidschicht Gateelektroden der Transistoren (T1 bis T4) sowie ein Verbindungsnetzwerk herstellt, das aus den Spaltenadressierleitungen (XI bis Xn) und Anschlüssen dieser Leitungen an die Gateelektroden der ersten Transistoren (T2) der vierten Mittel, aus den Zeilenadressierleitungen (YI bis Ym) oberhalb der Leisten der Ausgangsleitung (LS), wobei jede Leiste zwei Zeilenadressierleitungen aufweist, die je einem anderen auf jeder Seite der Leiste liegenden Adressierkreis zugeordnet sind, und aus Anschlüssen dieser Leitungen an die Drainelektroden der ersten Transistoren (T2) der vierten Mittel und an die Enden (5) der zweiten Anschlüsse (3), sowei aus einer Masseleitung (M) oberhalb der Vorspannungsleitung (LP) und aus Anschlüssen dieser Leitung an die Quellenelektroden der zweiten Transistoren (T5) der vierten Mittel, aus dem Zwischenpunkt (6) und aus den Enden (4) der ersten Anschlüsse (2), und aus Anschlüssen besteht, die innerhalb jedes Adressierkreises verlaufen, und daß auf die Oberfläche der Fotodetektoren eine Antireflexschicht aufgebracht ist, daß das Netz aus Zellen besteht, die sich zwischen zwei abwechselnden Schienen durch senkrechte Verschiebung voneinander ableiten lassen, während sie sich horizontal voneinander mittels Symmetrie ableiten lassen, und zwar einerseits bezüglich einer Schiene der Ausgangsleitung und andererseits bezüglich einer Schiene der Vorspannleitung wobei eine Zelle einen Fotodetektor und seinen Adressierkreis enthält.

## Claims

1. A matrix array of addressable photodetectors comprising an output line (LS) common to all said photodetectors, row addressing lines (YI to Ym), column addressing lines (XI to Xn), each photodetector being connected to ground and being associated to an addressing circuit comprising first means (T1) adapted to connect the photodetector to the output line (LS), characterized in that the addressing circuit further comprises second means (T3) adapted to connect the photodetector to a biasing line (LP) common to all said photodetectors and connected to a DC voltage source, third means (T4, R2) connected to said biasing line (LP) and to ground and adapted to control said second means, and fourth means (T2, R1) connected to one row addressing line (Y), to one column addressing line (X) and to ground and adapted to control said first and third means, wherein the first (T1), third (T4, R2) and fourth (T2, R1) means are turned off and the second means (T3) are turned on in the absence of signals on the row and column addressing lines, so that the current in the illuminated photodetector flows through the second means (T3) and the biasing line, and the first, third and fourth means are turned on and the second means are turned off when a signal is applied to the row and column addressing lines to select the photodetector associated with the addressing circuit, so that the current then flows through the first means (T1) into the output line (LS).

2. A photodetector array according to claim 1, characterized in that the first means of the addressing circuit consist of a transistor (T1), that the second means consist of a transistor (T3), that the third means consist of a transistor (T4) in series with a resistor (R2) connected to the biasing line (LP), a point common to the transistor and to the resistor being connected to a gate of the transistor (T3) of the second means, and that the fourth means consists of a transistor (T2) in series with a resistor (R1) connected to ground, the transistor being connected to the row addressing line (Y) and having a gate connected to the column addressing line (X), and a point common to the resistor and to the transistor being connected to a gate of the transistor (T1) of the first means.

3. A photodetector array according to claim 1, characterized in that the first means of the addressing circuit consist of a transistor (T1), that the second means consist of a transistor (T3), that the third means consist of a first transistor (T4) and a second transistor (T6) in series, the second transistor (T6) being connected to the biasing line (LP) and having a gate also connected to the biasing line (LP), a point common to the first and second transistors being connected to a gate of the transistor (T3) of the second means, and that the fourth means consist of a first transistor (T2), and a second transistor (T5) in series, the second transistor (T5) being connected to ground and having a gate connected to the first transistor (T2), the first transistor (T2) being connected to the row addressing line (Y) and having a gate connected to the column addressing line (X), a point common to the first and second transistors being connected to a gate of the transistor (T1) of the first means.

4. A photodetector array according to claim 2, characterized in that there is formed over an entire surface of a low-resistivity $P^+$ type substrate wafer a high-resistivity $P^-$ type layer, that there are formed in the high-resistivity layer N type areas to constitute on the one hand with the high-resistivity $P^-$ layer junctions corresponding to the photodetectors (PhD), to the sources (S) and the drains (D) of the transistors (T2, T4) of the third and fourth means, and on the other hand the resistors (R1, R2), one end of the resistor (R1) of the fourth means being in contact with the biasing line, first connections (2) each extending the resistor (R1) of the fourth means, second connections (3) each extending the drain of the transistor (T2) of the fourth means, the output line (LS) and the biasing line (LP) in the form of bars, an output line bar and a biasing line bar being disposed side by side and constituting a set of bars, the array comprising a plurality of sets of parallel bars, and each photodetector (PhD) and the transistors (T2, T4) and the resistors (R1, R2) of the third and fourth means of its addressing circuit, and the first and the second connections (2, 3) connected to its addresssing circuit being disposed between two sets of bars, the sources and drains of the transistors (T1) of the first means being respectively common to the photodetectors and to the output line (LS), the sources and drains of the transistors (T3) of the second means being respectively common to the photodetectors and to the biasing line (LP), that the surface of the wafer, with the exception of the photodetectors and of part of the sources and drains of the transistors (T2, T4) of the third and fourth means, is covered with a thin oxide layer ($SiO_2$), that contact openings are made in the oxide layer at one end (5) of each of the second connections (3) opposite the drain which it extends, at each end (c) of the resistors (R2) of the third means and at each end (b) of the resistors (R1) of the fourth means, to gain access to the N layer, and at one end (4) of each of the first connections (2) opposite the resistor (R1) that it extends, to gain access to the high-resistivity $P^-$ layer, that there are produced by depositing a metal which is a good conductor of electricity, the source and drain electrodes of the transistors (T2, T4) of the third and fourth means, in the parts not covered with oxide, contacts with the N and $P^-$ layers in the contact openings, and on the oxide, the gate electrodes of the transistors (T1 to T4) and an interconnection network consisting of the column addressing lines (Xl to Xn) and the connections of the latter with the gate electrodes of the transistors (T2) of the fourth means, the row addressing lines (Yl to Ym) over the output line (LS) bars, each bar comprising a row addressing line, and the connections of the latter with the drains of the transistors (T2) of the fourth means and the ends (5) of the second connections (3), a ground line (M) above the bars of the biasing line (LP) and connections of the latter with the resistors (R1) of the fourth means and the ends (4) of the first connections (2), and connections internal to each addressing circuit, that then an antireflection coating is deposited on the surface of the photodetectors, and that the array is constituted of cells derived from one another by vertical and horizontal sliding, each cell comprising a photodetector and its addressing circuit.

5. A photodetector array according to claim 3, characterized in that there is formed over an entire surface of a low-resistivity $P^+$ type substrate wafer a high-resistivity $P^-$ type layer, that there are formed in the high-resistivity layer N type areas to constitute on the one hand with the high-resistivity $P^-$ layer junctions corresponding to the photodetectors (PhD), to the sources (S) and the drains (D) of the transistors (T2, T4, T5, T6) of the third and fourth means, the drain of the second transistor (T6) of the third means being in contact with the biasing line, and on the other hand, first connections (2) each extending the source of the second transistor (T5) of the fourth means, second connections (3) each extending the drain of the first transistor (T2) of the fourth means, the output line (LS) and the biasing line (LP) in the form of bars, an output line bar and a biasing line bar being disposed side by side and constituting a set of bars, the array comprising a plurality of sets of parallel bars, and each photodetector (PhD) and the transistors (T2, T4, T5, T6) of the third and fourth means of its addressing circuit, and the first and the second connections (2, 3) connected to its addressing circuit being disposed between two sets of bars, the sources and drains of the transistors (T1) of the first means being respectively common to the photodetectors and to the output line (LS), the sources and drains of the transistors (T3) of the second means being respectively common to the photodetectors and to the biasing line (LP), that the surface of the wafer, with the exception of the photodetectors and of part of the sources and drains of the transistors (T2, T4, T5, T6) of the third and fourth means, is covered with a thin oxide layer (SiO$_2$), that contact openings are made in the oxide layer at one end (5) of each of the second connections (3) opposite the drain which it extends, and at an intermediate point (6) of each of the first connections (2), to gain access to the N layer, and at one end (4) of each of the first connections (2) opposite the source that it extends, to gain access to the high-resistivity P$^-$ layer, that there are produced by depositing a metal which is a good conductor of electricity, the source and drain electrodes of the transistors (T2, T4, T5, T6) of the third and fourth means, in the parts not covered with oxide, contacts with the N and P$^-$ layers in the contact openings, and on the oxide, the gate electrodes of the transistors (T1 to T4) and an interconnection network consisting of the column addressing lines (XI to Xn) and the connections of the latter with the gate electrodes of the first transistors (T2) of the fourth means, the row addressing lines (YI to Ym) over the output line (LS) bars, each bar comprising a row addressing line, and the connections of the latter with the drains of the first transistors (T2) of the fourth means and the ends (5) of the second connections (3), a ground line (M) above the biasing line (LP) and connections of the latter with the sources of the second transistors (T5) of the fourth means, the intermediate point (6) and the ends (4) of the first connections (2), and connections internal to each addressing circuit, that then an anti-reflection coating is deposited on the surface of the photodetectors, and that the array is constituted of cells derived from one another by vertical and horizontal sliding, each cell comprising a photodetector and its addressing circuit.

6. A photodetector array according to claim 2, characterized in that there is formed over an entire surface of a low-resistivity P$^+$ type substrate wafer a high-resistivity P$^-$ type layer, that there are formed in the high-resistivity layer N type areas to constitute on the one hand with the high-resistivity P$^-$ layer junctions corresponding to the photodetectors (PhD), to the sources (S) and the drains (D) of the transistors (T2, T4) of the third and fourth means, and on the other hand the resistors (R1, R2), one end of the resistor (R1) of the fourth means being in contact with the biasing line, first connections (2) each extending the resistor (R1) of the fourth means, second connections (3) each extending the drain of the transistor (T2) of the fourth means, the output line (LS) and the biasing line (LP) in the form of alternating bars, the array comprising a plurality of alternating bars, and each photodetector (PhD) and the transistors (T2, T4) and the resistors (R1, R2) of the third and fourth means, and the first and the second connections (2, 3) connected to its addressing circuit being disposed between two alternating bars, the sources and drains of the transistors (T1) of the first means being respectively common to the photodetectors and to the output line (LS), the sources and drains of the transistors (T3) of the second means being respectively common to the photodetectors and to the biasing line (LP), that the surface of the wafer, with the exception of the photodetectors and of part of the sources and drains of the transistors (T2, T4) of the third and fourth means, is covered with a thin oxide layer (SiO$_2$), that contact openings are made in the oxide layer at one end (5) of each of the second connections (3) opposite the drain which it extends, at each end (c) of the resistors (R2) of the third means and at each end (b) of the resistors (R1) of the fourth means, to gain access to the N layer, and at one end (4) of each of the first connections (2) opposite the resistor (R1) that it extends, to gain access to the high-resistivity P$^-$ layer, that there are produced by depositing a metal which is a good conductor of electricity, the source and drain electrodes of the transistors (T2, T4) of the third and fourth means, in the parts not covered with oxide, contacts with the N and P$^-$ layers in the contact openings, and on the oxide, the gate electrodes of the transistors (T1 to T4) and an interconnection network consisting of the column addressing lines (XI to Xn) and the connections of the latter with the gate electrodes of the transistors (T2) of the fourth means, the row addressing lines (YI to Ym) over the output line (LS) bars, each bar comprising two row addressing lines, each alotted to a different addressing circuit located on either side of said bar, and connections of the latter with the drains of the transistors (T2) of the fourth means and the ends (5) of the second connections (3), a ground line (M) above the bars of the biasing line (LP), and connections of the latter with the ends (b) of the resistors (R1) of the fourth means and the ends (4) of the first connections (2), and connections internal to each addressing circuit, that then an anti-reflection coating is deposited on the surface of the photodetectors, and that the array is constituted of cells derived between two alternating bars from one another by vertical sliding, and derived in horizontal direction from one another by symmetry, on the one hand, with respect to a bar of the output line and, on the other hand, with respect to a bar of the biasing line, a cell comprising a photodetector and its addressing circuit.

7. A photodetector array according to claim 3, characterized in that there is formed over an entire surface of a low-resistivity P$^+$ type substrate wafer a high-resistivity P$^-$ type layer, that there are formed in the high-resistivity layer N type areas to constitute on the one hand with the high-resistivity P⁻ layer junctions corresponding to the photodetectors (PhD), to the sources (S) and the drains (D) of the transistors (T2, T4, T5, T6) of the third and fourth means, the drain of the second transistor (T6) of the third means being in contact with the biasing line, and on the other hand, first connections (2) each extending the source of the second transistor (T5) of the fourth means, second connections (3) each extending the drain of the first transistor (T2) of the fourth means, the output line (LS) and the biasing line (LP) in the form of alternating bars, the array comprising a plurality of alternating bars, and each photodetector (PhD) and the transistors (T2, T4, T5, T6) of the third and fourth means of its addressing circuit, and the first and the second connections (2, 3) connected to its addressing circuit being disposed between two alternating bars, the sources and drains of the transistors (T1) of the first means being respectively common to the photodetectors and to the output line (LS), the sources and drains of the transistors (T3) of the second means being respectively common to the photodetectors and to the biasing line (LP), that the surface of the wafer, with the exception of the photodetectors and of part of the sources and drains of the transistors (T2, T4, T5, T6) of the third and fourth means, is covered with a thin oxide layer (SiO₂), that contact openings are made in the oxide layer at one end (5) of each of the second connections (3) opposite the drain which it extends, and at an intermediate point (6) of each of the first connections (2), to gain access to the N layer, and at one end (4) of each of the first connections (2) opposite the source that it extends, to gain access to the high-resistivity P⁻ layer, that there are produced by despositing a metal which is a good conductor of electricity, the source and drain electrodes of the transistors (T2, T4, T5, T6) of the third and fourth means, in the parts not covered with oxide, contacts with the N and P⁻ layers in the contact openings, and on the oxide, the gate electrodes of the transistors (T1 to T4) and an interconnection network consisting of the column addressing lines (Xl to Xn) and the connections of the latter with the gate electrodes of the first transistors (T2) of the fourth means, the row addressing lines (Yl to Ym) over the output line (LS) bars, each bar comprising two row addressing lines each alotted to a different addressing circuit located on either side of said bar, and the connections of the latter with the drains of the first transistors (T2) of the fourth means and the ends (5) of the second connections (3), a ground line (M) above the biasing line (LP) and connections of the latter with the sources of the second transistors (T5) of the fourth means, the intermediate point (6) and the ends (4) of the first connections (2), and connections internal to each addressing circuit, and that then an anti-reflection coating is deposited on the surface of the photodetectors, and that the array is constituted of cells derived between two alternating lines from one another by vertical sliding, and derived in horizontal direction from one another by symmetry, on the one hand, with respect to a bar of the output line and, on the other hand, with respect to a bar of the biasing line, a cell comprising a photodetector and its addressing circuit.

# FIG.1

FIG.2

FIG.3

0 130 529

FIG.4

# FIG.5

G   Yk   SiO2   M   G                    Si3N4              G   Yℓ   SiO2   M   G

PhD   LS   LP   N                              LS        LP   PhD

P−

P+

# FIG.6

LS   LP   LS   LP   LS   LP   LS   LP

— Xi

1                1                1

— Xj

1                1                1

— Xk

# FIG. 7

# FIG. 8

# FIG. 9

FIG.10